# EUROPÄISCHE PATENTSCHRIFT

(11) **EP 1 579 230 B1**
(45) Veröffentlichungstag und Bekanntmachung des Hinweises auf die Patenterteilung: **03.05.2006**
(21) Anmeldenummer: 03795761.0
(22) Anmeldetag: 18.12.2003
(51) Int. Cl.: G01R 31/3185

(54) **VORRICHTUNG UND VERFAHREN ZUR BILDUNG EINER SIGNATUR**
DEVICE AND METHOD FOR CREATING A SIGNATURE
DISPOSITIF ET PROCEDE POUR CREER UNE SIGNATURE

(30) Priorität: 20.12.2002 DE 10261250; 04.11.2003 DE 10351442
(43) Veröffentlichungstag der Anmeldung: 28.09.2005
(73) Patentinhaber: ROBERT BOSCH GMBH, 70442 Stuttgart (DE)
(72) Erfinder: HARTER, Werner, 75428 Illingen (DE); ANGERBAUER, Ralf, 71701 Schwieberdingen (DE); BOEHL, Eberhard, 72768 Reutlingen (DE)
(86) Internationale Anmeldenummer: PCT/DE2003/004177
(87) Internationale Veröffentlichungsnummer: WO 2004/057356

(56) Entgegenhaltungen:
- HLAWICZKA A ET AL: "A linear code-preserving signature analyzer COPMISR" VLSI TEST SYMPOSIUM, 1997., 15TH IEEE MONTEREY, CA, USA 27 APRIL-1 MAY 1997, LOS ALAMITOS, CA, USA,IEEE COMPUT. SOC, US, 27. April 1997 (1997-04-27), Seiten 350-355, XP010227465 ISBN: 0-8186-7810-0
- BADURA D ET AL: "Low cost BIST for EDAC circuits" TEST SYMPOSIUM, 1997. (ATS '97). PROCEEDINGS., SIXTH ASIAN AKITA, JAPAN 17-19 NOV. 1997, LOS ALAMITOS, CA, USA,IEEE COMPUT. SOC, US, 17. November 1997 (1997-11-17), Seiten 410-415, XP010258760 ISBN: 0-8186-8209-4
- S K GUPTA, DK PRADHAN: "Utilization of On-Line (Concurrent) Checkers during Built-In-Self-Test and Vice Verca" IEEE TRANSACTIONS ON COMPUTERS, Bd. 45, Nr. 1, 1. Januar 1996 (1996-01-01), Seiten 63-73, XP002277483
- BISWAS G P ET AL: "Design of t-UED/AUED codes from Berger's AUED code" VLSI DESIGN, 1997. PROCEEDINGS., TENTH INTERNATIONAL CONFERENCE ON HYDERABAD, INDIA 4-7 JAN. 1997, LOS ALAMITOS, CA, USA,IEEE COMPUT. SOC, US, 4. Januar 1997 (1997-01-04), Seiten 364-369, XP010211538 ISBN: 0-8186-7755-4

## Beschreibung

### Stand der Technik

Für die Bildung von Signaturen werden MISR-Schaltungen benutzt (MISR = Multiple Input Signature Register), wie sie beispielsweise in der Veröffentlichung Built-In Test for VLSI: Pseudorandom Techniques, von Paul H. Bardell, William H. McAnney und Jacob Savir auf Seite 124 f beschrieben sind. Dabei ist eine vorgegebene Anzahl an Schieberegistern vorgesehen, an welche zu prüfende Daten in einer Folge angelegt werden. Dabei werden die parallel anstehenden Daten eingekoppelt und in einem vorgegebenen Takt durch die Schieberegister weitergeschoben. Nach einer genau festgelegten Anzahl von Datenwörtern und Takten liegt in den Schieberegistern dann ein Signaturwert vor, der mit einem vorbekannten Signaturwert vergleich- und überprüfbar ist. Um einen Ablauf und die dabei angelegten Daten auf Fehlerfreiheit zu prüfen, genügt es, den erhaltenen Signaturwert mit dem erwarteten Signaturwert zu vergleichen. Dabei können auch die vorbekannten Signaturwerte auf diese Weise ermittelt werden.

Problematisch wird das Verfahren und die Vorrichtung aus dem Stand der Technik dann, wenn zu einem Zeitpunkt T ein Fehler an einem bestimmten Eingang vorliegt, da dann zunächst ein falscher Wert in das betroffene Schieberegister geschrieben wird. Die berechnete Endsignatur wird deshalb von der erwarteten Signatur abweichen. Tritt jedoch zusätzlich zu einem nachfolgenden Zeitpunkt T+1 an einem nachfolgenden, insbesondere direkt nachfolgenden Eingang ein Fehler auf, so wird der ursprüngliche Fehler am ersten Eingang nach dem Verschieben durch die Schieberegister mit einer Anzahl von Takten, die dem Abstand der Eingänge und Zeitpunkte entspricht, insbesondere mit einem Takt wieder kompensiert, wenn keine Rückkopplungsverzweigung des MISR also der Signaturerzeugungsschaltung dazwischen liegt. So werden Fehler, die zu solch problematischen Zeitpunkten und Datenwortpositionen auftreten, bei der Signaturbildung nicht bemerkt.

Eine Möglichkeit, bei der Einspeicherung Vorsorge zu treffen, um diese Problematik auszuschließen, ist die Einspeisung des inversen Datenwortes folgend auf ein Datenwort, so dass ein Fehler in jedem Fall nicht kompensiert, sondern bemerkt wird. Dies verdoppelt aber die Anzahl der notwendigen Operationen und Takte.

So zeigt sich, dass der Stand der Technik nicht in jeder Hinsicht optimale Ergebnisse zu liefern vermag, und es ergibt sich daraus die Aufgabe, eine verbesserte Vorrichtung und ein verbessertes Verfahren zur Beherrschung der oben genannten Problematik im Rahmen der Bildung von Signaturen zu entwickeln.

Zum oben diskutierten relevanten Stand der Technik gehöven die Documente : HLAWICZKA A ET AL: "A linear code-preserving signature analyzer COPMISR", VLSI TEST SYMPOSIUM, 1997, MONTEREY, Seiten 350-355, XP010227465;
BADURA D ET AL: "Low cost BIST for EDAC circuits", TEST SYMPOSIUM, 1997, JAPAN, XP010258760;
S K GUPTA, DK PRADHAN: "Utilization of On-Line (Concurrent) Checkers during Built-In-Self-Test and Vice Verca", IEEE TRANSACTIONS ON COMPUTERS, Bd. 45, Nr. 1, Seiten 63-73, XP002277483;
BISWAS G P ET AL: "Design of t-UED/AUED codes from Berger's AUED code", VLSI DESIGN, 1997, Seiten 364-369, XP010211538.

### Vorteile der Erfindung

Die Erfindung geht aus von einer Vorrichtung und einem Verfahren zur Bildung einer Signatur, wobei eine vorgegebene Anzahl an Schieberegistern vorgesehen ist, an welche zu prüfende Eingangsdaten bitweise und parallel als aufeinander folgende Datenwörter angelegt werden und welche die Eingangsdaten in einem vorgebbaren Takt seriell weiterschieben und nach einer bestimmten Anzahl von Datenwörtern und Takten eine Signatur in den Schieberegistern gebildet wird, wobei vorteilhafter Weise zusätzlich ein Codegenerator vorgesehen ist, der wenigstens eine zusätzliche Bitstelle in wenigstens einem zusätzlichen Schieberegister aus jedem Datenwort in der Signatur erzeugt. D. h. vorteilhafter Weise wird das MISR um wenigstens eine Bitstelle erweitert, wobei diese Bitstelle jeweils aus dem jeweils anliegenden kompletten Datenwort gewonnen wird und in die Signatur mit eingeht. Dadurch kann vorteilhafter Weise die Sicherheit zur Beherrschung oben genannter Problematik erzielt werden, ohne eine Vielzahl von zusätzlichen Operationen und Takten bei der Signaturbildung durchzuführen.

Auf diese Weise wird eine Fehlermaskierung bei den genannten Mehrfachfehlern mit geringstem Schaltungsmehraufwand verhindert.

Weiterhin von Vorteil ist, dass die einzelnen Schieberegister durch Antivalenzpunkte, also XOR-Verknüpfungen verbunden sind und auch die einzelnen Bitstellen über diese Antivalenzpunkte eingekoppelt werden.

Ebenso ist es zweckmäßigerweise denkbar, statt einer Antivalenzverknüpfung, also einem Antivalenzpunkt einen Äquivalenzpunkt, also ein negiertes XOR zu verwenden, um die einzelnen Bitstellen zum Einen der Datenwörter und zum Anderen die wenigstens eine Bitstelle des Codegenerators in die entsprechenden Schieberegister einzukoppeln.

Vorteilhafter Weise ist der Codegenerator derart ausgebildet, dass dieser einen ECC-Code (Error Check and Correction) realisiert, wie beispielsweise einen Hamming-Code, einen Berger-Code oder einen Bose-Lin-Code, usw., um die an dem jeweiligen ECC-Code entsprechende Anzahl an Bitstellen einer entsprechenden Anzahl an zusätzlichen Schieberegistern zur Signaturbildung vorzugeben. Im allgemeinsten Fall kann eine Codegeneratortabelle (festverdrahtet oder in SW) verwendet werden, um einem bestimmten Eingangsmuster der Datenworte bzw. Bits ein gewünschtes Codemuster beliebiger Länge zuzuordnen. Im einfachsten Fall ist der Codegenerator vorteilhafter Weise derart ausgebildet, dass dieser ein Parity-Bit bildet und dieses einem zusätzlichen Schieberegister vorgibt.

Weitere Vorteile und vorteilhafte Ausgestaltungen ergeben sich aus der Beschreibung sowie den Merkmalen der Ansprüche.

### Beschreibung der Ausführungsbeispiele

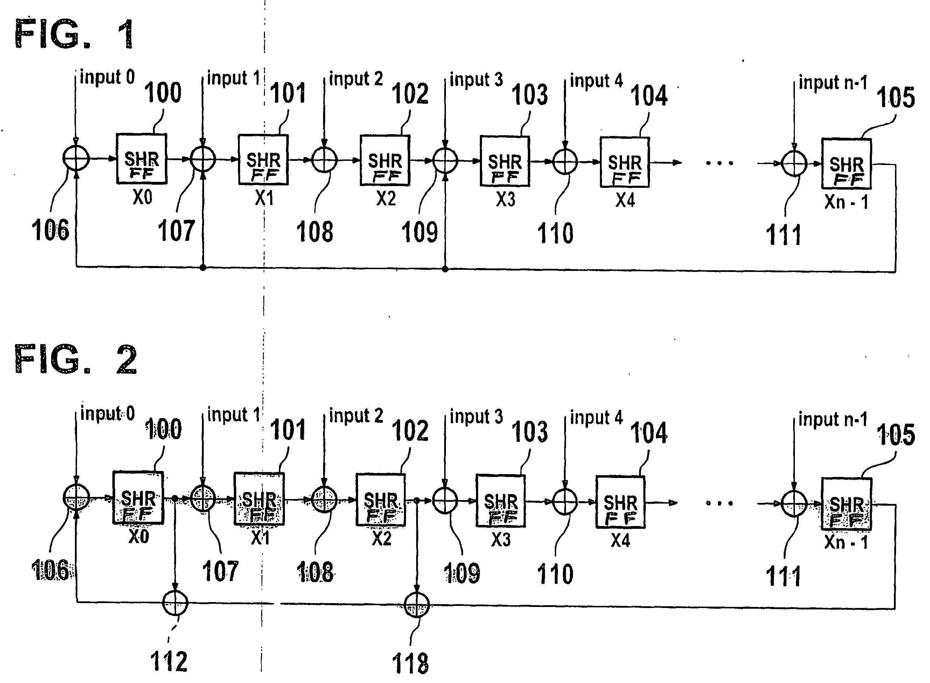

Figur 1 zeigt eine MISR-Schaltung mit Schieberegistern 100 bis 105 und Antivalenz-, also XOR-Verknüpfungspunkten 106 bis 111. Entsprechend der Rückkopplung ist hier ein modularer Typ dargestellt. Dabei werden die Eingänge Input 0, Input 1, Input 2, Input 3, Input 4 und Input n-1 in die Schieberegister eingekoppelt, die den entsprechenden Bitstellen der angelegten Datenwörter entsprechen sowie in einem vorgegebenen Takt eingelesen und durchgeschoben. In den Schieberegistern ergeben sich dann die Zustände X0, X1, X2, X3, X4 und Xn-1, wobei n eine natürliche Zahl größer Null ist und in diesem konkreten Beispiel sogar mindestens 6 entspricht.

Figur 2 zeigt ebenfalls ein MISR und ebenfalls mit den Schieberegistern 100 bis 105 sowie den Antivalenz-, also XOR- Verknüpfungen 106 bis 111. Weiterhin sind zusätzlich zwei XOR-Verknüpfungen 112 und 118 dargestellt, die in diesem Beispiel nach Schieberegister 100 und Schieberegister 102 bedient werden. Es handelt sich hierbei somit um den Standardtyp eines MISR, wobei die Einkoppelpunkte, also die Antivalenzverknüpfungen 112 und 118 ebenso wie deren Anzahl beliebig in der MISR gewählt werden können. Auch hier sind die Eingänge von 0 bis n-1 dargestellt und ebenso die Zustände der Schieberegister von X0 bis Xn-1 mit n ∈ N.

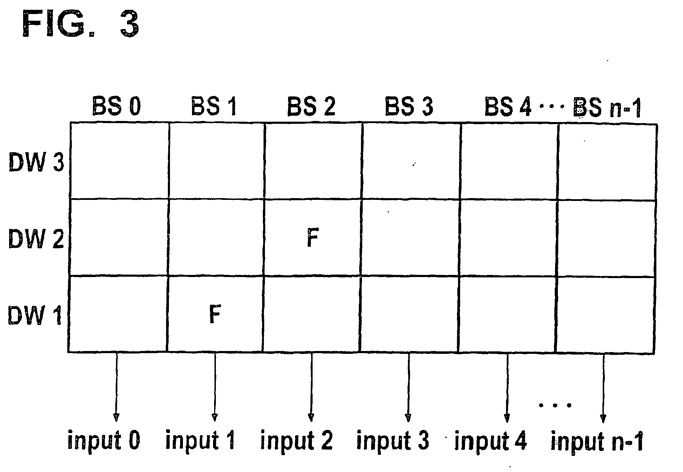

Figur 3 zeigt nun die Darstellung dreier Datenwörter DW1, DW2 und DW3, die in dieser Folge an die Eingänge Input 0 bis Input n-1 angelegt werden sollen. Die einzelnen Bitstellen sind mit BSO bis BSn-1 dargestellt. Liegt nun beispielsweise zum Zeitpunkt T im Datenwort DW 1, bestimmt für Input 1 ein Fehler F an und ebenso zum späteren Zeitpunkt T+1 im Datenwort DW2 also bei Input 2, so kompensieren sich diese Fehler nach dem Verschieben mit einem Takt in dem MISR. Gleiches gilt für weitere Fehlerkonstellationen, die aufgrund des Einkoppelzeitpunktes bzw. der Position im Datenwort und dem entsprechenden Input eine Kompensation zur Folge haben.

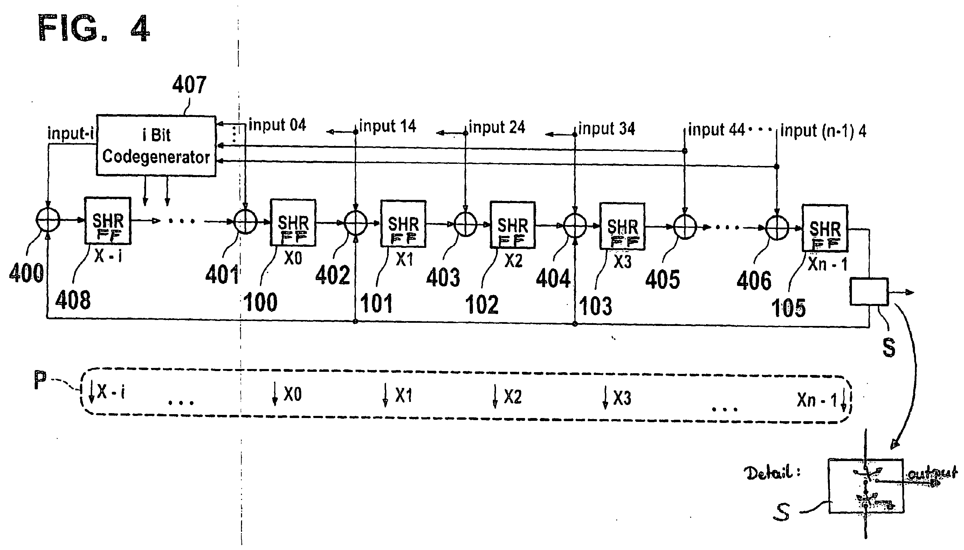

In Figur 4 nun wird das MISR um einen i Bit-Codegenerator 407 erweitert. Dabei stellt i ebenfalls eine natürliche Zahl größer Null die Anzahl der Bits dar, die durch den Codegenerator in das MISR eingekoppelt werden entsprechend des verwendeten Codes bzw. ECC-Codes im Codegenerator. Entsprechend dieser Anzahl i der ausgegebenen Bitstellen des Codegenerators ist auch eine entsprechende Anzahl an Schieberegistern, hier mit 408 bezeichnet, zusätzlich zum MISR vorgesehen. Im einfachsten Fall erfolgt hier eine Parity-Bit-Bildung, so dass dann nur ein zusätzliches Schieberegister vorgesehen ist und ein weiterer Input -1.

An welcher Stelle im MISR das wenigstens eine zusätzliche Schieberegister bzw. der wenigstens eine zusätzliche Einkoppelpunkt, also Antivalenz- bzw. Äquivalenzpunkt eingebracht wird, ist frei wählbar und hier nur beispielhaft dargestellt. D. h. auch hier in Figur 4 sind wieder die üblichen Schieberegister 100 bis 105 dargestellt, wobei wenigstens ein zusätzliches Schieberegister 408 vorgesehen ist. Die Eingänge der erfindungsgemäßen Vorrichtung Input 04, Input 14, Input 24, Input 34, Input 44 und Input (n-1)4 sind hier nicht nur auf die Antivalenzpunkte, also die XOR-Verknüpfungen geführt, sondern auch dem i Bit-Codegenerator zugeführt. So wird im vorgegebenen Takt aus jedem eingehenden Datenwort eine Zusatzinformation, abhängig vom verwendeten Code (insbesondere ECC), generiert und einer entsprechenden Anzahl von Schieberegistern eingespeist. In diesem Beispiel sind als XOR-Verknüpfungspunkte die Elemente 400 bis 406 vorgesehen, wobei sich in unserem Beispiel neben dem Eingang Inpunt -i und dem Zustand X -i des Schieberegisters 408 die üblichen Zustände X0, X1*,* X2, X3 und Xn-1 der Schieberegister ergeben. Die zusätzlichen Pfeile als Ausgang des i Bit-Codegenerators 407 deuten an, dass in einer anderen Ausflihrungsform eben mehr als nur eine zusätzliche Bitstelle in das MISR geschrieben werden, abhängig vom verwendeten Code.

Bei Verwendung eines Hamming-Codes ergibt sich beispielsweise also bei ECC für Einzelfehlerkorrektur, bei 4 Bit Nutzdaten 3 Bit Korrekturcode. Bei ECC Ein-FehlerKorrektur mit 8 Bit Nutzdaten ergeben sich 4 Bit Korrekturcode. Bei 16 Bit Nutzdaten ergeben sich 5 Bit Korrekturcode und bei 32 Bit Nutzdaten 6 Bit Korrekturcode. Also allgemein 2^{k} >= m+k+1, wobei m der Anzahl der Nutzbits als natürliche Zahl größer 0 entspricht und k den Codebits oder Korrekturbits bzw. dem Korrekturcode ebenfalls als natürliche Zahl. Soll zusätzlich eine Zweifach-Fehler-Detektion erfolgen, ist jeweils 1 Bit mehr Korrekturcode vorzusehen.

Wird beispielsweise ein Berger-Code verwendet, sind bei 4 Bit-Nutzdaten zusätzlich 3 Codebits 5 Zustände vorzusehen, bei 8 Bit Nutzdaten zusätzlich 4 Codebits für 9 Zustände. Bei 16 Bit Nutzdaten zusätzlich 5 Codebits bei 17 Zuständen und bei 32 Bit Nutzdaten zusätzlich 6 Codebits bei 33 Zuständen. Hier heißt es allgemein 2^{k} >= m+1 bzw. k >= Id(m+1), wobei m der Nutzbitanzahl der Daten entspricht und k der Codebitanzahl bzw. dem Korrekturcode.

Auch weitere Codes, wie der Brose-Lin-Code sind hierbei möglich, wobei die Anzahl der Codierungsbits dabei gleich ist wie die des Berger-Codes aber die Prüfbits lediglich Modulo 4 oder Modulo 8 genommen werden.

Entsprechend der Anzahl dieser Codierungsbits k ist somit auch die Anzahl der Ausgänge des Codegenerators vorzusehen, also zusätzliche Eingänge (inputs) -i, wobei i = 1 bis k ∈ N und eine ebensolche entsprechende Anzahl an Schieberegistern und Verknüpfungspunkten.

Das MISR wird somit um mindestens eine Stelle erweitert, indem mindestens ein Parity- oder anderer Code aus den ursprünglichen Daten Input 0 bis Input n - 1 gewonnen wird und in die Signatur, hier im Beispiel in Figur 4 für den modularen Typ (Figur 1) gezeichnet, mit eingeht. Gleiches gilt natürlich auch für den Standardtyp (Figur 2). Der Codegenerator kann somit ein Parity-Generator sein mit i = 1, wobei in diesem Fall genau ein zusätzliches Flip-Flop notwendig ist. Für den Fall, dass beispielsweise am Input 3 ein Fehler auftritt, wird zusätzlich am Input -1, also dem Parity-Input, ein veränderter Wert eingespeist. Um diesen Wert im Fehlerfall zu maskieren, ist dann genau im nächsten Takt sowohl an Input 4 als auch an Input 0 ein Fehler notwendig. Es liegt hier also ein höherer Hamming-Abstand vor und durch das notwendige präzise zeitliche Verhalten bei der Fehlermaskierung mit Doppelfehler verringert sich die Wahrscheinlichkeit der Maskierung deutlich.

Mit einem noch höheren Aufwand an Codebits, wie oben erwähnt, kann der Hamming-Abstand beliebig weiter erhöht werden. Wird statt der Antivalenz- eine Äquivalenzverknüpfung zur Einkopplung verwendet, erzielt man zwar geringfügig geringere Redundanz, aber immer noch eine deutlich geringere Fehlerauslöschungswahrscheinlichkeit als im Stand der Technik.

Als weitere Möglichkeit ergibt sich für den Codegenerator 407 noch eine Tabellenzuordnung, also der Einsatz einer Codegeneratortabelle, bei der abhängig von der eingehenden Bitkombination des Datenwortes eine vorgegebene Anzahl an Codebits in eine entsprechende Anzahl Schieberegister eingekoppelt wird. Durch eine solche Codegeneratortabelle ist eine beliebige Zuordnung von eingehenden Datenbits zu ausgegebenen Codierungsbits möglich.

Zum Auslesen der gebildeten Signatur aus dem MISR ist im seriellen Fall ein Schaltmittel S vorgesehen, welches die Rückkoppelleitung unterbricht und ein Auslesen der Register seriell ermöglicht. Zum Anderen besteht die Möglichkeit, wie mit dem Buchstaben P und der gestrichelten Linie angedeutet, die Schieberegister parallel und damit die Signatur in einem Zuge aus dem MISR auszugeben, um diese mit einer entsprechenden erwarteten Signatur zu vergleichen.

Die Erfindung stellt also einen deutlich höheren Sicherheitsfaktor dar als eine gewöhnliche MISR und dies bei deutlich geringerem Aufwand als eine ständig notwendige Inversion der Datenwörter zum Ausgleich einer Fehlermaskierung.

Damit ist die Erfindung bei allen sicherheitskritischen Anwendungen, insbesondere im Fahrzeugbereich wie bei Bremsensteuerungen (ABS, ASR, ESP, usw.), steer-by-wire, break-by-wire, also allgemein x-by-wire, Airbag, Motorsteuerung, Getriebesteuerung, usw. einsetzbar. Ebenso Einsatz finden kann die Erfindung bei Mikrocontrollern oder anderen Halbleiterstrukturen im Rahmen eines Tests sowie bei allen BIST-Strukturen (built-in-self-test) und auch zur Optimierung von Produktionstests.

## Patentansprüche

1. Vorrichtung zur Bildung einer Signatur, wobei eine vorgegebene Anzahl an Schieberegistern (100-105) vorgesehen ist, an welche zu prüfenden Eingangsdaten bitweise und parallel als aufeinander folgende Datenwörter (DW1, DW2, DW3) angelegt werden und welche die Eingangsdaten in einem vorgebbaren Takt seriell weiter schieben, wobei nach einer bestimmten Anzahl von Datenwörtern und Takten eine Signatur in den Schieberegistern gebildet wird **dadurch gekennzeichnet, dass** in der Vorrichtung zusätzlich ein Codegenerator (407) mit wenigstens einem zusätzlichen Schieberegister vorgesehen ist, in dem wenigstens eine zusätzliche Bitstelle aus jedem Datenwort der Signatur erzeugt wird.

2. Vorrichtung nach Anspruch 1, **dadurch gekennzeichnet, dass** die einzelnen Schieberegister durch Antivalenzpunkte (400-406) verbunden sind und die einzelnen Bits der Datenwörter in diese Antivalenzpunkte ebenso wie die wenigstens eine zusätzliche Bitstelle des Codegenerators zur Signaturbildung eingekoppelt werden.

3. Vorrichtung nach Anspruch 1, **dadurch gekennzeichnet, dass** die einzelnen Schieberegister durch Äquivalenzpunkte (400-406) verbunden sind und die einzelnen Bits der Datenwörter in diese Äquivalenzpunkte ebenso wie die wenigstens eine zusätzliche Bitstelle des Codegenerators zur Signaturbildung eingekoppelt werden.

4. Vorrichtung nach Anspruch 1, **dadurch gekennzeichnet, dass** der Codegenerator derart ausgebildet ist, dass dieser einen ECC Code (Error Check and Carrection Code) realisiert und die dem jeweiligen ECC Code entsprechende Anzahl an Bitstellen einer entsprechenden Anzahl an zusätzlichen Speicherelernenten zur Signaturbildung vorgibt

5. Vorrichtung nach Anspruch 1,**dadurch gekennzeichnet, dass** der Codegenerator derart ausgebildet ist, dass dieser ein Parity-Bit bildet und dem einen zusätzlichen Schieberegister vorgibt.

6. Vorrichtung nach Anspruch 4,**dadurch gekennzeichnet, dass** der Codegenerator derart ausgebildet ist, dass dieser einen Hamming Code realisiert.

7. Vorrichtung nach Anspruch 4,**dadurch gekennzeichnet, dass** der Codegenerator derart ausgebildet ist, dass dieser einen Berger Code realisiert.

8. Vorrichtung nach Anspruch 4,**dadurch gekennzeichnet, dass** der Codegenerator derart ausgebildet ist, dass dieser einen Bose-Lin Code realisiert.

9. Vorrichtung nach Anspruch 4,**dadurch gekennzeichnet, dass** der Codegenerator derart ausgebildet ist, dass dieser eine allgemeine Codegeneratortabelle realisiert.

10. Verfahren zur Bildung einer Signatur, wobei eine vorgegebene Anzahl an Speicherelenienten eines Schieberegisters (100-115) vorgesehen ist, an welche zu prüfenden Eingangsdaten bitweise und parallel als aufeinander folgende Datenwörter (DW1, DW2, DW3) angelegt werden und welche die Eingangsdaten in einem vorgebbaren Takt seriell weiter schieben, wobei nach einer bestimmten Anzahl von Datenwörtern und Takten eine Signatur in dem Schieberegister gebildet wird **dadurch gekennzeichnet, dass** in der Vorrichtung zusätzlich ein Codegenerator (407) mit wenigstens einem zusätzlichen Schieberegister vorgesehen ist, in dem wenigstens eine zusätzliche Bitstelle aus jedem Datenwort der Signatur erzeugt wird.

## Revendications

1. Dispositif pour créer une signature, dans lequel un nombre prédéterminé de registres à décalage (100 - 105) reçoivent des données d'entrée à vérifier par bits et parallèlement sous forme de mots-machine successifs (DW1, DW2, DW3), et décalent les données d'entrée par série selon un cycle pouvant être prédéterminé, et après un certain nombre de mots-machine et de cycles, une signature est créée dans les registres à décalage,
**caractérisé en ce que**
le dispositif comporte en outre un générateur de code (407) comprenant au moins un registre à décalage supplémentaire, dans lequel est généré au moins un emplacement de bit supplémentaire à partir de chaque mot-machine de la signature.

2. Dispositif selon la revendication 1,
**caractérisé en ce que**
les registres à décalage individuels sont reliés par des points d'antivalence (400 - 406), et les bits individuels des mots-machine, dans ces points d'antivalence, sont intégrés tout comme au moins un emplacement de bit supplémentaire du générateur de code pour la création de la signature.

3. Dispositif selon la revendication 1,
**caractérisé en ce que**
les registres à décalage individuels (400 - 406) sont reliés par des points d'équivalence et les bits individuels des mots-machine, dans ces points d'équivalence, sont intégrés tout comme au moins un emplacement de bit supplémentaire du générateur de code pour la création de la signature.

4. Dispositif selon la revendication 1,
**caractérisé en ce que**
le générateur de code est configuré pour réaliser un code ECC (Error Check and Correction Code, code de vérification et de correction d'erreur) et pour prédéterminer pour la création de la signature le nombre d'emplacements de bit correspondant au code ECC respectif pour un nombre correspondant d'éléments de mémoire supplémentaires.

5. Dispositif selon la revendication 1,
**caractérisé en ce que**
le générateur de code est configuré pour former un bit de parité et prédéterminer pour celui-ci un registre à décalage supplémentaire.

6. Dispositif selon la revendication 4,
**caractérisé en ce que**
le générateur de code est configuré pour réaliser un code de Hamming.

7. Dispositif selon la revendication 4,
**caractérisé en ce que**
le générateur de code est configuré pour réaliser un code de Berger.

8. Dispositif selon la revendication 4,
**caractérisé en ce que**
le générateur de code est configuré pour réaliser un code de Bose-Lin.

9. Dispositif selon la revendication 4,
**caractérisé en ce que**
le générateur de code est configuré pour réaliser un tableau de générateur de code général.

10. Procédé de création d'une signature, selon lequel un nombre prédéterminé d'éléments de mémoire d'un registre à décalage (100 - 115), reçoivent des données d'entrée à vérifier par bits et parallèlement sous forme de mots-machine successifs (DW1, DW2, DW3), et décalent les données d'entrée par série selon un cycle pouvant être prédéterminé, et après un certain nombre de mots-machine et de cycles, une signature est créée dans le registre à décalage,
**caractérisé en ce que**
le dispositif comporte en outre un générateur de code (407) comprenant au moins un registre à décalage supplémentaire, dans lequel est généré au moins un emplacement de bit supplémentaire à partir de chaque mot-machine de la signature.

## Claims

1. Device for creating a signature, provision being made of a prescribed number of shift registers (100-105) to which input data (which are to be checked) are applied bit by bit and in parallel in the form of successive data words (DW1, DW2, DW3) and which serially shift the input data further using a prescribable clock, and a signature being created in the shift registers after a particular number of data words and clock pulses, **characterized in that** the device additionally contains a code generator (407) having at least one additional shift register in which at least one additional bit position is produced from each data word in the signature.

2. Device according to Claim 1, **characterized in that** the individual shift registers are connected by means of antivalence points (400-406), and the individual bits of the data words as well as the at least one additional bit position of the code generator are injected into these antivalence points in order to create the signature.

3. Device according to Claim 1, **characterized in that** the individual shift registers are connected by means of equivalence points (400-406), and the individual bits of the data words as well as the at least one additional bit position of the code generator are injected into these equivalence points in order to create the signature.

4. Device according to Claim 1, **characterized in that** the code generator is designed in such a manner that it produces an ECC code (error check and correction code) and specifies the number of bit positions (corresponding to the respective ECC code) for a corresponding number of additional memory elements in order to create the signature.

5. Device according to Claim 1, **characterized in that** the code generator is designed in such a manner that it forms a parity bit and specifies it for the one additional shift register.

6. Device according to Claim 4, **characterized in that** the code generator is designed in such a manner that it produces a Hamming code.

7. Device according to Claim 4, **characterized in that** the code generator is designed in such a manner that it produces a Berger code.

8. Device according to Claim 4, **characterized in that** the code generator is designed in such a manner that it produces a Bose-Lin code.

9. Device according to Claim 4, **characterized in that** the code generator is designed in such a manner that it produces a general code generator table.

10. Method for creating a signature, provision being made of a prescribed number of memory elements of a shift register (100-105), to which input data (which are to be checked) are applied bit by bit and in parallel in the form of successive data words (DW1, DW2, DW3) and which serially shift the input data further using a prescribable clock, and a signature being created in the shift register after a particular number of data words and clock pulses, **characterized in that** the device additionally contains a code generator (407) having at least one additional shift register in which at least one additional bit position is produced from each data word in the signature.
